(19) Europäisches Patentamt
European Patent Office
Office européen des brevets

(11) **EP 1 076 388 B1**

(12) **EUROPEAN PATENT SPECIFICATION**

(45) Date of publication and mention
of the grant of the patent:
**11.03.2009 Bulletin 2009/11**

(21) Application number: **00902891.1**

(22) Date of filing: **09.02.2000**

(51) Int Cl.:
**H01S 5/20** (2006.01)

(86) International application number:
**PCT/JP2000/000730**

(87) International publication number:
**WO 2000/052795 (08.09.2000 Gazette 2000/36)**

(54) **Semiconductor laser**

Halbleiterlaser

Laser à semiconducteur

(84) Designated Contracting States:
**CH DE FR GB IT LI**

(30) Priority: **26.02.1999 JP 4944699**

(43) Date of publication of application:
**14.02.2001 Bulletin 2001/07**

(73) Proprietor: **FURUKAWA ELECTRIC CO., LTD.**
**Tokyo 100-8322 (JP)**

(72) Inventors:
• **MUKAIHARA, Toshikazu**
**c/o The Furukawa El. Co., Ltd**
**Tokyo 100-8322 (JP)**
• **YAMAGUCHI, Takeharu**
**Tokyo 100-8322 (JP)**

• **KASUKAWA, Akihiko,**
**The Furukawa Electric Co., Ltd.**
**Tokyo 100-8322 (JP)**

(74) Representative: **Pätzold, Herbert**
**Steubstrasse 10**
**82166 Gräfelfing (DE)**

(56) References cited:
| | |
|---|---|
| **JP-A- 5 084 892** | **JP-A- 5 267 778** |
| **JP-A- 6 291 368** | **JP-A- 9 008 406** |
| **JP-A- 9 036 427** | **JP-A- 9 270 558** |
| **JP-A- 9 312 275** | **JP-A- 10 256 662** |
| **JP-A- 11 251 629** | **JP-A- 49 090 494** |
| **JP-A- 53 060 588** | **JP-A- 59 023 579** |

**Description**

Field of the Invention

The present invention relates to a semiconductor laser device, more in detail, to the semiconductor laser device in which an optical output and a lasing spectrum operate in a stable relation with respect to injected current, and more specifically to the high power semiconductor pumping source, such as a semiconductor laser, which is most suitable as an optical amplifier for an optical communication system.

Background Art

The prior art document JP 59 023 579 A discloses a semiconductor light emitting device comprising a semiconductor substrate having a bandgap energy and an active layer overlying the substrate and a bottom surface opposite to the main surface having unevenness for diffused reflection.

The priort art document JP 09270558A discloses a semiconductor laser comprising a semiconductor substrate having a bandgap $Eg_1$ and an active layer having a bandgap $Eg_2$ smaller than $Eg_1$.

A semiconductor laser device outputting a light having a wavelength of a 980 nm band, for example, an InGaAs-based semiconductor laser element is frequently employed as various light sources in an optical communication system, for example, as a pumping light source for an optical fiber amplifier.

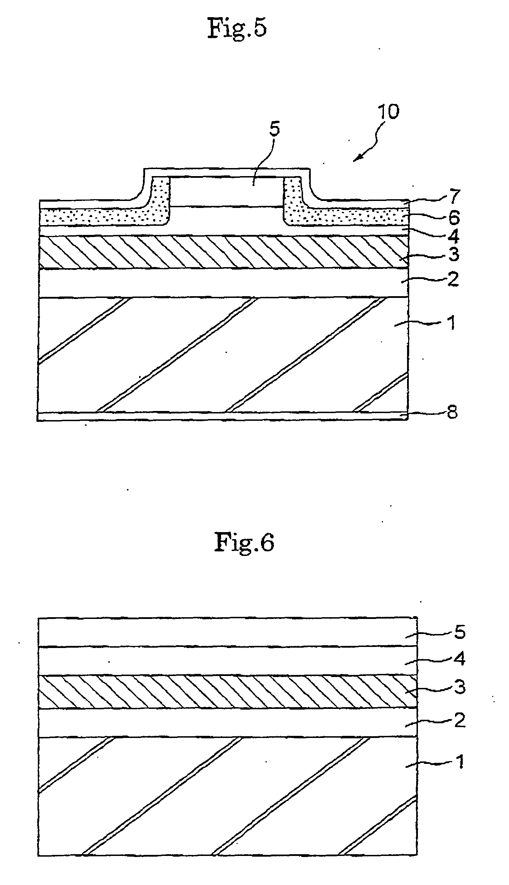

The structure of the conventional InGaAs-based laser element of the 980 nm range (hereinafter referred to as "InGaAs-based laser element") will be described referring to Fig.5 which is a cross sectional view showing a conventional InGaAs-based laser element.

A conventional InGaAs-based laser element 10 basically has a layered structure shown in Fig.5 which is manufactured by sequentially depositing, by means of epitaxial growth, an n-AlGaAs cladding layer 2 having a thickness of 2 $\mu$m, a quantum well active layer 3 including InGaAs having a thickness of 7 nm and GaAs having a thickness of 10 nm, a p-AlGaAs cladding layer 4 having a thickness of 2$\mu$m and a GaAs cap layer 5 having a thickness of 0.3$\mu$m, on an n-GaAs substrate 1 having a thickness of 100$\mu$m.

The top portion having a thickness of 1 $\mu$m of the cladding layer 4 and the cap layer 5 are subjected to an etching to form a mesa-stripe having a width of 4 $\mu$m. A passivation film 6 made of SiN is formed on the entire surface other than the top portion of the mesa (the top surface of the cap layer 5) to make a window for supplying current therethrough.

A Ti/Pt/Au metal layered film 7 is formed on the passivation film 6 as a p-side electrode, and an AuGe/Ni/Au metal layered film 8 is formed on the bottom surface of the substrate 1 as an n-side electrode.

Then, a conventional method for manufacturing the InGaAs-based laser element 10 will be described referring to Fig.6 showing a vertical section of the InGaAs-based laser element 10 during the manufacture.

At first, the n-AlGaAs cladding layer 2 having a thickness of 2$\mu$m, the quantum well active layer 3 including InGaAs having a thickness of 7 nm and GaAs having a thickness of 10 nm, the p-AlGaAs cladding layer 4 having a thickness of 2 $\mu$m and the GaAs cap layer 5 having a thickness of 0.3$\mu$m are sequentially formed on the n-GaAs substrate 1 by using an MOCVD method.

Then, the cap layer 5 and the upper portion of the cladding layer 4 are selectively etched by a thickness of 1 $\mu$m to form a mesa stripe having a width of 4$\mu$m, thereby forming the passivation film 6 on the entire surface of the mesa stripe. The passivation film on the top surface of the mesa stripe is removed to form a window through which current is to be injected.

Then, the bottom surface of the substrate 1 is polished until the thickness of the substrate becomes 100 $\mu$m. Thereafter, the Ti/Pt/Au metal layered film 7 functioning as a p-side electrode and the AuGe/Ni/Au metal layered film 8 functioning as an n-side electrode are formed on the passivation film 6 and on the bottom surface of the substrate 1, respectively, by means of vapor deposition to provide the InGaAs-based laser element 10.

Since the bandgap energy $Eg_1$ of the substrate 1 of the conventional InGaAs-based laser element 10 is 1.41 eV and the bandgap energy $Eg_2$ of the active layers 3 is 1.27 eV which is smaller than the bandgap energy $Eg_1$, the light emitted from the active layer can travel within the substrate.

However, the conventional InGaAs-based laser element has the following two problems in connection with the characteristics of the laser element.

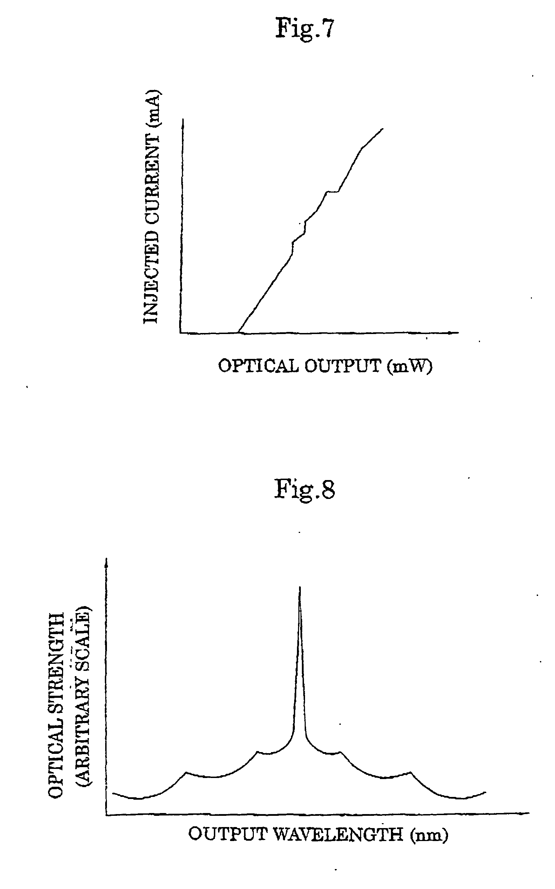

A first problem is that a linearity between current and an optical output is not excellent and kinks are observed in the current-optical output characteristic as shown in Fig.7. The disturbance on the current-optical output characteristic makes it difficult to obtain a stable automatic power control (APC) for the InGaAs-based laser element based on the current-optical output characteristic.

A second problem is that a ripple appears at a specified wavelength interval, for example, a 3 nm interval on the wavelength characteristic of a lasing spectrum as shown in a graph of Fig.8 with wavelength as abscissa and with optical strength at the wavelength as ordinate. In this situation, a phenomenon occurs in which the lasing mode skips every 3 nm interval with respect to the injected current, and mode hopping noise is generated. The lasing mode becomes a single longitudinal mode due to the ripples and is weakened with respect to the returned ray.

Accordingly, it is difficult to precisely amplify the input signals to keep the signal powers suitably reflecting constant the input signals using the conventional optical fiber amplifier using the InGaAs-based laser element as a pumping source.

This disadvantage of the semiconductor light emitting device is extremely undesirable used for the pumping source of an optical fiber telecommunication system.

In view of the foregoing, an object of the present invention is to provide a semiconductor light emitting device such as a semiconductor laser element which can obtain a multiple longitudinal mode lasing spectrum generating reduced ripples and a stable optical output with respect to injected current.

Disclosure of the Invention

The present inventors have found the following matters after investigating the reasons of causing the above problems of the InGaAs-based laser element.

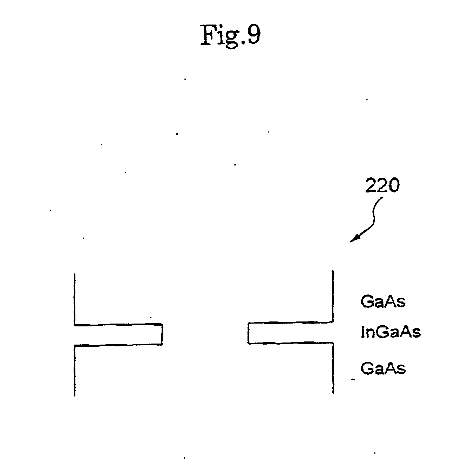

Either problem arises because light is regularly reflected on the bottom surface of the substrate. Since the bottom surface of the substrate is of a mirror surface after the substrate is polished at the bottom surface to have a specified thickness, for example, to a thickness of $100\mu m$ in the conventional InGaAs-based laser element, part of the light travelling within the substrate and reflected on the bottom surface of the substrate is combined with the light in the active layer as shown in Fig.9, and a coupled resonator is formed by combination of a substrate resonator formed by the regular reflection on the substrate and an original Fabry-Perot resonator, thereby making the lasing wavelength unstable.

The present inventors have reached to a concept that the above problems can be solved by changing the bottom surface of the substrate from a mirror surface to an uneven surface for (1) changing the regular reflection of the light at the bottom surface of the substrate to suppress the combination of the reflected light and the light in the active layer and for (2) suppressing the resonator function due to the regular reflection on the substrate to extinguish the ripples, thereby completing the present invention after repeated experiments.

Although the in-plane semiconductor laser device has been exemplified for discussing the problems in the above description, the problems are also present in a surface emission semiconductor light emitting device.

A semiconductor laser device of the present invention, for solving the above problems, including a semiconductor substrate having a bandgap energy of $Eg_1$, and at least one active layer having a bandgap energy of $Eg_2$ smaller than $Eg_1$ and overlying main surface of the semiconductor substrate is characterized by a bottom surface of the semiconductor substrate opposite to the main surface having unevenness for diffused reflection.

Since the bottom surface of the semiconductor substrate is processed to be a surface for generating the diffused reflection of light having the minute unevenness, the light reflecting from the bottom surface of the substrate to the active layer is reduced, and the optical output from semiconductor light emitting device and the lasing spectrum stably operate with regard to injected current.

As far as the bandgap energy of the semiconductor substrate is larger than that of the active layer, the present invention can be applied to an in-plane semiconductor light emitting device and to a surface emission semiconductor light emitting device, and can be also applied to, for example, GaAs-based, InGaAs-based and InP-based semiconductor laser devices regardless of compositions of the semiconductor substrate and the active layer.

The size of the unevenness of the bottom surface of the semiconductor substrate should be determined depending on the wavelength of the semiconductor laser device, but can be defined by surface roughness Rq (root-mean square value of roughness). The surface roughness Rq at a 980 nm band may be between 10 nm and $10\mu m$ both inclusive. The size of the unevenness defined by surface roughness (root-mean square value of roughness) can be measured with a contact type or a light wave interference type surface roughness measuring device or an atomic force microscope (AFM)

The surface roughness Rq used herein is a root of an average value obtained by integrating the square of a deviation from a central line to a roughness curve f(x) in an evaluation length of 1m followed by averaging as shown in the following equation (I).

$$Rq = \sqrt{\frac{1}{lm}\int_0^{lm} f(x)^2\,dx} \qquad (I)$$

In the semiconductor laser device of the present invention, the active layer desirably includes a single quantum well.

The lasing spectrum of the conventional semiconductor laser device is unstable with respect to a returning light because the lasing spectrum is the single longitudinal mode. However, the unevenness of the polished bottom surface extinguishes the ripples to realize the multiple longitudinal mode semiconductor light emitting device in the present invention.

In order to realize the further stabilized multiple longitudinal mode lasing, a single quantum well structure including InGaAs/GaAs is desirably employed.

The reason thereof is as follows.

A degree of easing the occurrence of the single longitudinal mode lasing is defined as the below equation, and related with a spontaneous emission coefficient $\beta_{SP}$ showing a degree of contribution of spontaneous emission to a laser mode. The single longitudinal mode lasing is more easily generated with the decrease of the spontaneous emission coefficient $\beta_{SP}$, and the multiple longitudinal mode lasing is more easily generated with the increase of $\beta_{SP}$.

$$\beta_{SP} = (\Gamma \lambda^4 K)/(4\pi^2 n^3 V \delta \lambda)$$

Wherein r is a confinement coefficient of light in the active layer, $\lambda$ is a lasing wavelength, K is a factor reflecting complexity of a horizontal mode, "n" is an equivalent refractive index, V is a volume of an active layer, and $\delta \lambda$ is a spread of a spectrum.

Accordingly, $\beta_{SP}$ is increased by decreasing the volume of the active layer "V" by means of employing a single quantum well as the active layer to generate the multiple longitudinal mode lasing.

Brief Description of Drawings

Fig.1(a) is a cross sectional view showing a layered structure of a semiconductor laser element in accordance with an embodiment of the present invention, and Fig.1(b) is a diagram showing a band gap of an active layer.

Fig.2 is a graph showing a relation between injected current and an optical output power.

Fig.3 is a graph showing a relation between an output wavelength and an optical strength.

Fig.4 is a band gap diagram of a modified active layer.

Fig.5 is a cross sectional view showing a conventional InGaAs-based laser element.

Fig.6 is a vertical sectional view showing a layered structure during manufacture of the conventional InGaAs-based laser element.

Fig.7 is a graph showing a relation between injected current and an optical output of the conventional laser element.

Fig.8 is a graph showing a relation between an output wavelength and an optical strength of the conventional laser element.

Fig.9 is a schematic view showing a state in which a light is regularly reflected at a bottom surface of a substrate.

Best Mode for Practicing the Invention

Now, embodiments of the present invention will be more concretely and specifically described with reference to accompanying drawings.

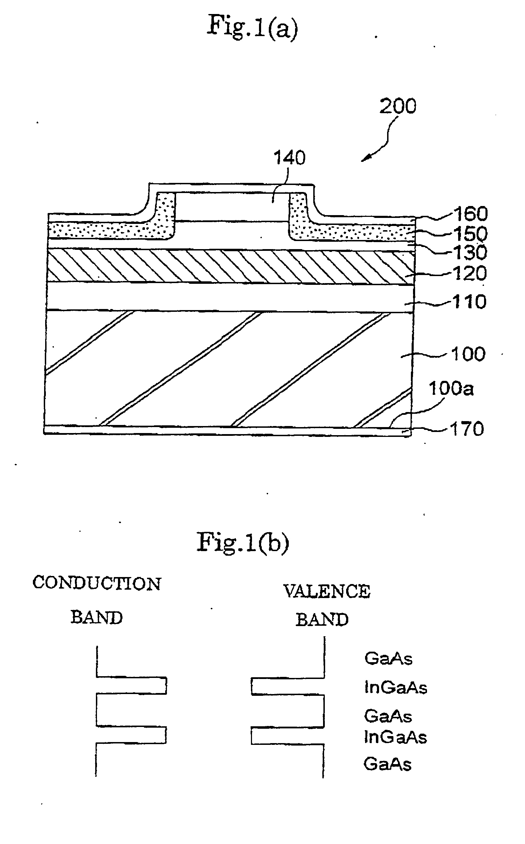

A present embodiment is an example of a semiconductor laser element of the present invention, and Fig.1(a) is a cross sectional view showing a layered structure of the semiconductor laser element in accordance with the embodiment of the present invention, and Fig.1(b) is a diagram showing a band gap of an active layer.

A semiconductor laser device 200 in accordance with the present embodiment is an InGaAs-based in-plane emitting laser element of a 980 nm band. The light emitting device has a layered structure shown in Fig.1(a) which is manufactured by sequentially depositing, by means of epitaxial growth, a n-AlGaAs cladding layer 110 having a thickness of 2 $\mu$m, an InGaAs (thickness of 7 nm)/GaAs (thickness of 10nm) quantum well active layer 120 having band gap energy of 1.27 electron volts, a p-AlGaAs cladding layer 130 having a thickness of 2$\mu$m and a GaAs cap layer 140 having a thickness of 0.3$\mu$m, on a n-GaAs substrate 100 having a thickness of 100$\mu$m and having band gap energy of 1.41 electron volts.

In the present embodiment, the InGaAs/GaAs quantum well active layer 120 is formed as a double quantum well structure including InGaAs/GaAs as shown in Fig.1(b).

The upper layer by a thickness of 1$\mu$m of the second clad layer 130 and the cap layer 140 are shaped to provide mesa stripes having a width of 4μm, and a passivation film 150 made of SiN is formed on the entire surface of the cap layer 140 and the cladding layer 130 except for the top surface of the mesa stripe (top surface of the cap layer 140). A window for supplying current therethrough is formed on the top surface of the cap layer 140.

A TiPtAu metal layered film 160 is formed on the passivation film 150 as a p-side electrode, and a AuGe/Ni/Au metal layered film 170 is formed on the bottom surface 100a of the substrate 100 as a n-side electrode.

In the InGaAs-based laser element 200 of the present embodiment, the bottom surface 100a of the substrate 100 is treated to have continuous and minute unevenness in a wave shape thereby performing the diffused reflection of light.

The size of the unevenness is defined by employing surface roughness Rq (root-mean square value of roughness) measured with a differential step contact type surface roughness measuring device, and Rq=100nm.

In order to manufacture the InGaAs-based laser element 200 of the present embodiment, similarly to the conventional method, the n-AlGaAs cladding layer 110 having a thickness of 4 μm, the InGaAs (thickness of 7 nm)/ GaAs (thickness of 10 nm) quantum well active layer 120, the p-AlGaAs cladding layer 130 having a thickness of 2μm and the GaAs cap layer 140 having a thickness of 0.3μm are sequentially grown on the n-GaAs substrate 100 employing an MOCVD method.

After the mesa stripe having a width of 4 having a thickness of 4μm is formed, a SiN film as the passivation film 150 is deposited on the entire surface of the substrate, and the passivation film 150 of the top portion of the mesa stripe is removed to form a window for injecting current.

Then, the bottom surface 110a of the substrate 100 is polished until the thickness of the substrate becomes 100μm. During the polishing of the present embodiment, lapping powder having a larger particle size is employed for forming the unevenness of which the root-mean square value of roughness "Rq" is 100nm on the polished surface.

Thereafter, similarly to the conventional method, the TiPtAu metal layered film 160 functioning as a p-side electrode and the AuGe/Ni/Au metal layered film 170 functioning as an n-side electrode are formed on the passivation film 150 and on the bottom surface of the substrate, respectively, by means of vapor deposition to provide the InGaAs-based laser element 200 shown in Fig.1(a).

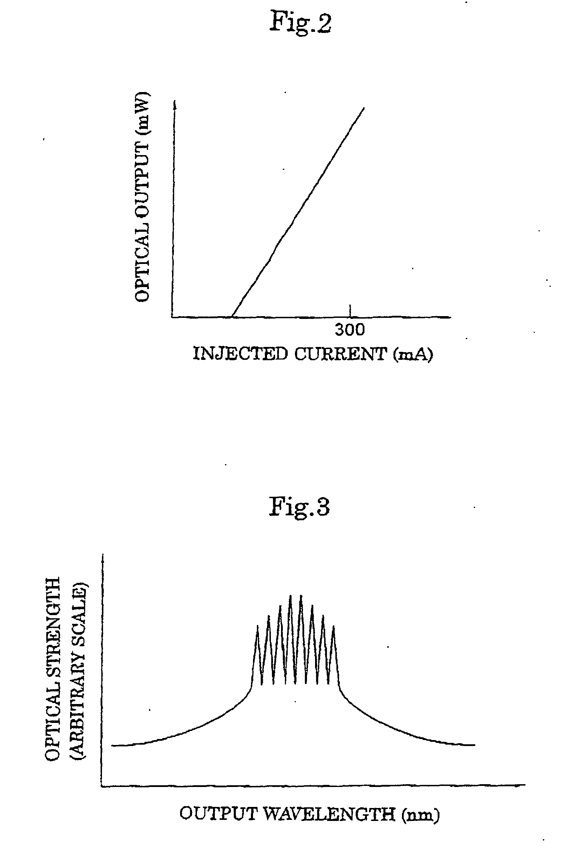

After a trial piece similar to the semiconductor light emitting device 200 of the present embodiment was manufactured employing lapping powder including particles of which a size was 9μm to make unevenness of which Rq was 100 nm on the bottom surface of a substrate, the current-optical output characteristic and a lasing spectrum of the trial piece were measured to obtain measurement results shown in Figs.2 and 3.

The current-optical output characteristic shows a linearity having substantially no kinks in the injected current at least up to 300 mA as shown in Fig.3. In the lasing spectrum shown in Fig.3, ripples occurring in the conventional semiconductor laser element are extinguished and the spectrum is lased in the longitudinal multi-mode.

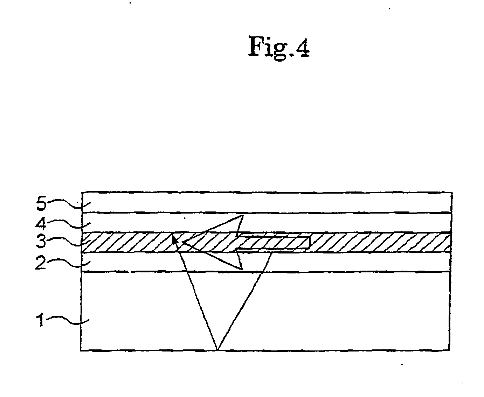

Another embodiment is shown in Fig.4.

The present embodiment is an modified example of the above embodiment, and includes substantially the same configurations as those of the above embodiment except that the InGaAs/GaAs quantum well active layer 220 is replaced with a single quantum well structure including two GaAs barrier layers and an InGaAs well layer between the barrier layers as shown in Fig.4.

The single quantum well structure of the active layer can generate more stable multiple longitudinal mode lasing.

Industrial Applicability of the Invention

In accordance with the present invention, the generation of kinks in the current-optical output characteristic and of ripples in the lasing spectrum occurring in a conventional semiconductor laser device can be suppressed by reducing an amount of light reflecting from the semiconductor substrate bottom surface to the active layer by means of making the continuous and minute unevenness acting as a surface for diffused reflection of light on the semiconductor substrate bottom surface opposite to the active layer, thereby realizing the semiconductor laser device in which an optical output and a multiple longitudinal mode lasing spectrum stably operate with regard to injected current.

The present invention can provide the semiconductor laser device most suitable for an optical amplifier of an optical fiber telecommunication system.

**Claims**

1. A semiconductor laser (200) comprising a semiconductor substrate (100) having a bandgap energy of Eg1, and an active layer (120, 220) grown in crystal having a bandgap energy of Eg2 smaller than Eg1 and overlying the semiconductor substrate, **characterize in that**
a bottom surface of the semiconductor substrate (100) opposite to the main surface having unevenness for diffused reflection of light.

**2.** The semiconductor laser (200) as defined in claim 1, wherein the depth of the unevenness is such that a root-mean square value of roughness "Rq" thereof is between 10 nm and 10 μm m both inclusive.

**3.** The semiconductor laser (200) as defined in claim 1 or 2, wherein said active layer (120. 220) implements a single quantum well.

**4.** The semiconductor laser (200) according to one of the above claims 1 to 3, comprising an InGaAs- based in-plane emitting laser element.

**Patentansprüche**

**1.** Halbleiterlaser (200), der ein Halbleitersubstrat (100) mit einer Bandabstandsenergie Eg1 und einer aktiven Schicht (120; 220) umfasst, die in einem Kristall mit einer Bandabstandsenergie Eg2 aufwachsen gelassen wurde, die geringer ist als Eg1, und die auf dem Halbleitersubstrat liegt, **dadurch gekennzeichnet, dass** eine Unterseite des Halbleitersubstrats (100) gegenüber der Hauptseite eine Unebenheit für eine diffuse Lichtreflexion hat.

**2.** Halbleiterlaser (200) nach Anspruch 1, wobei die Tiefe der Unebenheit derart ist, dass ein quadratischer Mittelwert der Rauigkeit "Rq" davon zwischen 10 nm und 10 μm, beides einschließlich, liegt.

**3.** Halbleiterlaser (200) nach Anspruch 1 oder 2, wobei die genannte aktive Schicht (120, 220) eine einzige Quantummulde implementiert.

**4.** Halbleiterlaser (200) nach einem der obigen Ansprüche 1 bis 3, der ein planares Laserelement auf der Basis von InGaAs umfasst.

**Revendications**

**1.** Laser à semi-conducteur (200) comprenant un substrat semi-conducteur (100) présentant une énergie spectrale Eg1, et une couche active (120, 220) crue dans un cristal présentant une énergie spectrale Eg2 inférieure à Eg1 et recouvrant le substrat semi-conducteur, **caractérisé en ce que** une surface inférieure du substrat semi-conducteur (100) opposée à la surface principale présente des irrégularités afin d'assurer une réflexion diffuse de lumière.

**2.** Laser à semi-conducteur (200) selon la revendication 1, dans lequel la profondeur des irrégularités est telle qu'une valeur efficace de rugosité "Rq" de celle-ci est inclusivement comprise entre 10 nm et 10 μm.

**3.** Laser à semi-conducteur (200) selon la revendication 1 ou 2, dans lequel ladite couche active (120, 220) met en oeuvre un seul puits quantique.

**4.** Laser à semi-conducteur (200) selon l'une des revendications 1 à 3 précédentes, comprenant un élément laser à émission plane à base de InGaAs.

# Fig.1(a)

# Fig.1(b)

CONDUCTION
BAND

VALENCE
BAND

GaAs

InGaAs

GaAs

InGaAs

GaAs

## Fig.2

OPTICAL OUTPUT (mW)

300

INJECTED CURRENT (mA)

## Fig.3

OPTICAL STRENGTH (ARBITRARY SCALE)

OUTPUT WAVELENGTH (nm)

Fig.4

## Fig.5

## Fig.6

# Fig.7

INJECTED CURRENT (mA)

OPTICAL OUTPUT (mW)

# Fig.8

OPTICAL STRENGTH (ARBITRARY SCALE)

OUTPUT WAVELENGTH (nm)

## Fig.9

220

GaAs

InGaAs

GaAs

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 59023579 A

- JP 09270558 A